# EUROPEAN PATENT APPLICATION

(11) **EP 0 645 470 A1**
(43) Date of publication of application: **29.03.1995**
(21) Application number: 94114614.4
(22) Date of filing: 16.09.1994
(51) Int. Cl.: C23C 14/56

(54) **Process for barrier coating of plastic objects**

(30) Priority: 23.09.1993 US 125962
(71) Applicant: Becton Dickinson and Company, Franklin Lakes, New Jersey 07417-1880 (US)
(72) Inventor: Williams, Joel L., Cary, North Carolina 27511 (US); Burkett, Susan L., Hillsborough, North Carolina 27278 (US); McGuire, Shel, Omaha, Nebraska 68106 (JP)
(74) Representative: von Kreisler, Alek, Dipl.-Chem.

(57) **Abstract**

A method for sequentially depositing a silicon oxide based film as a barrier on a substrate. The film is useful for providing an effective barrier against gas permeability in containers and for extending shelf-life of containers, especially plastic evacuated blood collection devices.

## Description

### BACKGROUND OF THE INVENTION

### 1. Field of the Invention

This invention relates to a method for depositing a barrier coating to plastic containers for improving the effective barrier of the plastic container against gas and water permeability.

### 2. Description of the Related Art

In numerous fields of technology, it is necessary to apply very thin coatings of pure substances to certain objects. An example is window glass which is provided with a thin coating of metal oxide in order to filter certain wavelength ranges out of sunlight. In semi-conductor technology, thin coatings of one or more substances are often applied to a substrate. It is especially important that the thin coatings not only be pure, but also that they be precisely measured out so that the coating thickness and, in the case of coatings of chemical compounds, their composition will be accurately repeatable. These coating thicknesses are, as a rule, between two and several thousands of nanometers.

A variety of methods are known for applying thin coatings to films, glass and other substrates. Such processes for depositing SiOₓ onto plastic objects are disclosed in U.S. Patent Nos. 5,053,244 and 5,107,791 and European Patent No. 0 299 754. Most specifically, these processes can provide excellent barrier properties to plastic films which have not been exposed to dust. However, these processes provide only minor barrier properties to three-dimensional plastic objects or films that are exposed to dust.

It is believed that the inability to obtain a good barrier on three-dimensional plastic objects is due to the lack of cleanliness of the object's surface since most three dimension objects are exposed to dust during fabrication.

In the process of depositing SiOₓ on thin films, the SiOₓ barrier coating is applied under vacuum conditions to a clean film. Typically, film is extruded under very clean conditions and immediately wound into a large roll. As a consequence, the film surfaces, with the exception of the outside layer, are never exposed to particles in air such as dust.

It is believed that the reason for the lack or minimum improvement in permeability of three-dimensional objects coated with SiOₓ is that the surface of the three-dimensional object has a contaminated surface. It is further believed that the contamination is due to foreign surface particles that settle on the object due to its exposure to air.

Even though SiOₓ is evenly deposited on the surface of an object at about 500 to 1000 Å in thickness, because foreign surface particles, that are on the order of 5000 to 50000 Å in diameter, may be on the surface of the object, portions of the surface are not coated with the SiOₓ because of the shielding effect caused by the foreign surface particles.

Therefore, a need exists to remove and/or redistribute contamination from the surface of objects that are to be coated with SiOₓ to improve the process for applying SiOₓ to the objects and more particularly, to improve the barrier properties of the objects.

### SUMMARY OF THE INVENTION

The present invention is a process for sequentially depositing a barrier composition over the outer surface of an article, such as a composite container.

Preferably, the barrier composition is a silicon oxide based film. Such a film desirably is derived from volatile organosilicon compounds or gases.

Most preferably, the method for sequentially depositing a barrier coating on an article, such as a plastic collection tube comprises the following steps:
(a) evaporating a deposition material by heating;
(b) depositing a first deposition film onto the surface of the article;
(c) removing and/or redistributing foreign surface particles from the surface of the article; and
(d) depositing a second deposition film onto the surface of the article over the first deposition film by repeating steps (a) through (b) above.

The deposition material is preferably silicon and silicon oxide or silicon oxide alone.

Preferably, the foreign surface particles are removed and/or redistributed from the surface of the article by ultrasonic vibrations or wiping. Most preferably the foreign surface particles are removed and/or redistributed with pressurized gas.

Preferably, the film provides a transparent, translucent or colorless appearance and may have printed matter applied thereon.

Alternatively, the process of depositing a barrier coating on an article can be accomplished by plasma or sputtering a metal or metal oxide.

The advantage achieved by the process of sequentially depositing a barrier coating by evaporation with the intermittent removal and/or redistribution of foreign surface particles from the surface of the article is that improved permeability of the article is observed.

A further advantage is that the process of the present invention improves the permeability of three-dimensional objects that has not been achieved with conventional deposition processes typically used with thin films.

A significant advantage of the process of the present invention is that the intermittent step of removing and/or redistributing foreign surface particles on the surface of the article exposes the regions shielded by the foreign surface particles for the depositing of a second barrier coating. Therefore, a significant reduction in permeability of the article is due to the complete surface coverage by the barrier coating that is obtained by the sequential deposition technique and intermittent step of removing and/or redistributing the foreign surface particles.

### DESCRIPTION OF THE DRAWINGS

FIG. 1 is a general schematic diagram illustrating the sequential depositing of SiOₓ.

FIG. 2 is a general schematic diagram illustrating an evaporation system utilizing the various aspects of the present invention.

### DETAILED DESCRIPTION

The present invention may be embodied in other specific forms and is not limited to any specific embodiment described in detail which is merely exemplary. Various other modifications will be apparent to and readily made by those skilled in the art without departing from the scope and spirit of the invention. The scope of the invention will be measured by the appended claims and their equivalents.

The method for sequentially depositing a barrier coating on a substrate is preferably conducted in a previously evacuated chamber with means for evaporating a deposition material. The deposition material preferably comprises a combination of silicon and silicon oxide or silicon oxide alone.

A substrate is placed in an evacuated chamber which comprises an evaporation system. A first silicon oxide based film is deposited on the substrate by an evaporation process. The evaporation process includes heating certain deposition materials.

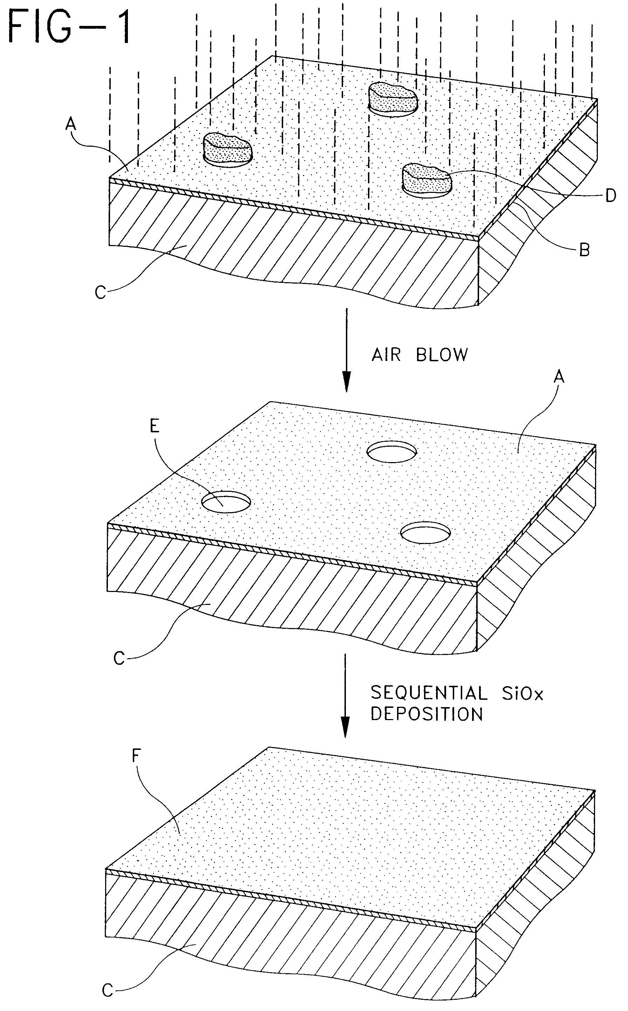

As shown in FIG. 1, the first silicon oxide based film A does not completely cover surface B of substrate C. It is believed that complete coverage cannot be achieved with the first silicon oxide based film because of surface shielding caused by foreign surface particles D. In effect, no silicon oxide based film is applied beneath the particles.

Therefore, before the second silicon oxide based film is applied, the shielding particles are removed and/or redistributed from the surface of the substrate with compressed gas. The compressed gas is most preferably air, nitrogen, argon or oxygen. The pressure of the gas is preferably at about 25 psi. Shielded regions E are exposed after the foreign surface particles are removed and/or redistributed with the compressed gas.

After the foreign surface particles are removed and/or redistributed with the compressed gas, the substrate is then again subjected to the evaporation process described above to deposit a second silicon based oxide film F and to produce a substantially pin hole free barrier coating on the substrate.

Most preferably, a combination of silicon and silicon oxide or silicon oxide alone is used as the deposition material, and at least one member selected from the group consisting of SiO, Si₂O₃, Si₃O₄ and SiO₂ is used as the silicon oxide. These silicon compounds may be crystalline or amorphous. In order to improve the durability, strength, etc.,. of the deposition layer, not more than 10%, based on the above deposition material, of silicon compounds other than the above-specified silicon oxides, or alloys or compounds such as oxides, silicides, silicates, fluorides, nitrides, carbides, etc. of metals other than silicon or a mixture of these may be incorporated to the above deposition material. Examples of these metals include tin, magnesium, aluminum, indium, manganese, silver, etc. The use of a small amount of metal in combination gives an effect of improving the degree of vacuum further owing to a reaction thereof with residual oxygen in a vacuum chamber. Among these metals, tin and indium provide good stability in deposition and give a desirable result.

In this invention, the heat evaporating portion comprises a heat evaporation member having means to hold the deposition material and means to evaporate the deposition material by heating. A means for evaporation by heating in this invention, there are used conventionally known heating methods such as resistance heating method, electron beam heating method, and high frequency induction heating method.

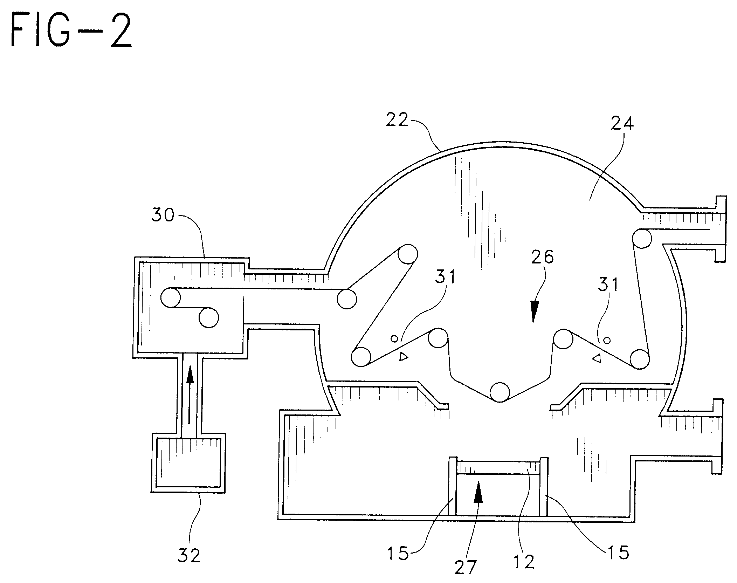

FIG. 2 is a schematic view showing an apparatus for the deposition of a barrier coating by evaporation. The apparatus has a vacuum chamber **22** connected to vacuum means (not shown). Within vacuum chamber **22**, there is a feeding track **24** which allows a substrate **10** to travel into the vacuum chamber. Within the vacuum chamber there is a heat evaporation member **27** below the feeding track wherein a deposition material **12** is heated. Heat evaporation member **27** uses a direct resistance heating method using an electrode **15**.

Preferably, the degree of vacuum of vacuum chamber **22**, is not more than 10⁻³ Torr. The thickness of the deposition layer or the substrate can be controlled by a film thickness sensor **31**.

The system for removing and/or redistributing foreign surface particles includes an enclosed chamber **30** with a compressed gas supply system **32** for removing and/or redistributing the foreign surface particles that may be on the substrate.

The substrate to be coated is loaded onto feeding track **24**. The feeding track then brings the substrate into the vacuum chamber where the deposition material is evaporated and coated onto the article. During the deposition process, substrate **10** is moved back and forth through the evaporation region **26**, a number of times in order that the film deposited on the outer surface of the substrate has a desired uniform thickness.

After a first coating of the silicon oxide based film has been deposited on the substrate, the substrate is subjected to a stream of compressed gas at about 25 psi in chamber **30**. Foreign surface particles on the substrate are removed and/or redistributed. The substrate is then returned to chamber **22** for a second coating of the silicon oxide based film.

The silicon oxide based film or blends thereof used in accordance with this disclosure, may contain conventional additives and ingredients which do not adversely affect the properties of articles made therefrom.

Various other modifications will be apparent to and may be readily made by those skilled in the art without departing from the scope and spirit of the invention.

A variety of substrates can be coated with a barrier composition by the process of the present invention. Such substrates include, but are not limited to packaging, containers, bottles, jars, tubes and medical devices.

A variety of processes are also available in addition to evaporation deposition for depositing a barrier composition. Such processes include, but are not limited to radio frequency discharge, direct or dual ion beam deposition, or sputtering.

## Claims

1. A method for sequentially depositing a deposition material on a plastic substrate in a previously evacuated chamber by evaporation comprising:
(a) evaporating a deposition material to form a gas stream inside the chamber;
(b) depositing a first coating of the deposition material on said substrate;
(c) removing and/or redistributing foreign surface particles from said substrate; and
(d) repeating steps (a) through (b) above, thereby depositing a second coating of a deposition material on said substrate.

2. The method of Claim 1, wherein said deposition material is silicon and silicon oxide or silicon.

3. The method according to Claim 1, wherein said foreign surface particles are removed and/or redistributed with a pressurized gas stream.

4. The method of Claim 1, wherein said foreign surface particles are removed and/or redistributed by wiping said substrate.

5. The method of Claim 1, wherein said foreign surface particles are removed and/or redistributed with ultrasonic vibrations.

6. The method of Claim 3 wherein said pressurized gas stream of step (c) is nitrogen or argon at about 25 psi.
